(19) Europäisches Patentamt
European Patent Office
Office européen des brevets

(11) **EP 2 023 485 A1**

(12) **EUROPEAN PATENT APPLICATION**
published in accordance with Art. 153(4) EPC

(43) Date of publication:
**11.02.2009 Bulletin 2009/07**

(51) Int Cl.:
*H03H 9/25* (2006.01)     *H01L 41/09* (2006.01)
*H01L 41/18* (2006.01)     *H03H 9/145* (2006.01)

(21) Application number: **07743195.5**

(22) Date of filing: **11.05.2007**

(86) International application number:
**PCT/JP2007/059760**

(87) International publication number:
**WO 2007/138840 (06.12.2007 Gazette 2007/49)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **30.05.2006 JP 2006149854**

(71) Applicant: **Murata Manufacturing Co. Ltd.**
**Nagaokakyo-shi, Kyoto 617-8555 (JP)**

(72) Inventor: **KANDO, Hajime**
**Nagaokakyo-shi, Kyoto-fu 617-8555 (JP)**

(74) Representative: **Thévenet, Jean-Bruno et al**
**Cabinet Beau de Loménie**
**158, rue de l'Université**
**75340 Paris Cédex 07 (FR)**

(54) **BOUNDARY ACOUSTIC WAVE DEVICE**

(57)     A boundary acoustic wave device in which a first medium to a fourth medium are laminated and an electrode is disposed between a first medium and a second medium is provided, wherein the boundary acoustic wave device has a small absolute value of temperature coefficient of delay time and good temperature characteristics. A boundary acoustic wave device (1) in which a first medium (11) to fourth medium (14) are laminated in that order and, an electrode including an IDT electrode (16) is disposed at an interface between the first medium (11) and the second medium (12), and in a structure formed by laminating the fourth medium (14)/the second medium (12)/the electrode/the first medium (11), the temperature coefficient of delay time TCD of a boundary acoustic wave takes on a positive value, the fourth medium or the second medium has a positive temperature coefficient of sound velocity TCV, the first medium (11) has a negative temperature coefficient of sound velocity TCV, and the sound velocity of transverse wave of the third medium (13) is specified to be smaller than the sound velocity of transverse wave of the fourth medium (14) and/or the second medium (12).

FIG.1

EP 2 023 485 A1

**Description**

Technical Field

The present invention relates to a boundary acoustic wave device used as, for example, a resonator and a filter. In particular, the present invention relates to a boundary acoustic wave device having a structure in which an electrode is disposed between a first medium and a second medium, and a third medium and a fourth medium are further laminated on the second medium.

Background Art

In recent years, boundary acoustic wave devices have been noted as resonators and band pass filters because package structures can be simplified.

The following Patent Document 1 discloses a boundary acoustic wave device, wherein the electromechanical coefficient is large, the propagation loss and the power flow angle are small, and the temperature coefficient of resonant frequency TCF is within an appropriate range. Here, an IDT electrode is disposed at an interface between a first medium made of a piezoelectric substrate and a second medium made of a $SiO_2$ film. Furthermore, it is described that the electromechanical coefficient and the temperature characteristics can be adjusted by adjusting the crystal orientation of a piezoelectric single crystal used as the piezoelectric substrate, the material for defining the IDT electrode, the film thickness, and the electrode finger pitch.

On the other hand, the following Patent Document 2 discloses a boundary acoustic wave device 101 schematically shown in Fig. 12. In the boundary acoustic wave device 101, the IDT electrode 115 is disposed at the interface between the first medium 111 made of a Y-cut X-propagation $LiNbO_3$ substrate and the second medium 112 made of a $SiO_2$ film. Furthermore, a third medium 113 made of a polycrystalline Si layer and a fourth medium 114 made of a $SiO_2$ film are laminated on the second medium 112 in that order.

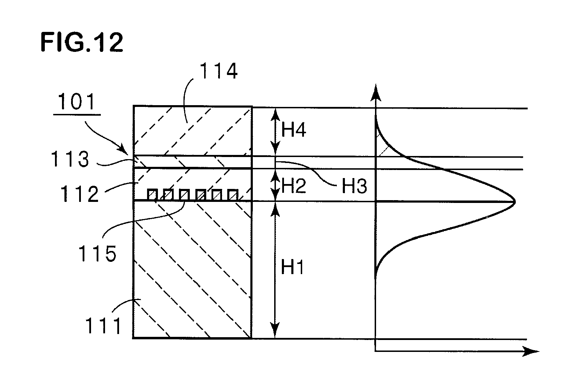

Here, it is described that frequency adjustment can be conducted by laminating the second medium 112 to the fourth medium 114. That is, the electrode 115 is formed between the first medium 111 having a film thickness of H1 and the second medium 112 having a film thickness of H2, and the third medium 113 having a film thickness of H3 is laminated, so that a laminate is obtained. The frequency control is conducted at this laminate stage. Then, the fourth medium 114 having a film thickness of H4 is laminated on the third medium 113. Regarding the thus obtained boundary acoustic wave device 101, the energy of the boundary wave becomes as shown in the right-hand part of Fig. 12. That is, in the fourth medium, the energy is distributed to only a small part. Therefore, according to the description, in the case where the frequency control is conducted at the above-described laminate stage and variations in frequency are reduced significantly, even when the fourth medium 114 is formed, it is possible to reduce variations in frequency.

Patent Document 1: WO2004-070946
Patent Document 2: WO2005-093949

Disclosure of Invention

In the boundary acoustic wave device described in Patent Document 1, when the substrate crystal orientation of the piezoelectric single crystal defining the piezoelectric substrate and the configuration of the IDT electrode are determined, the temperature coefficient of resonant frequency TCF and the temperature coefficient of delay time TCD are determined automatically. Therefore, it is difficult to obtain a boundary acoustic wave device having desired temperature characteristics.

On the other hand, in the boundary acoustic wave device described in Patent Document 2, the frequency adjustment in the production stage can easily be conducted by laminating the second medium to the fourth medium, as described above. Therefore, the boundary acoustic wave device exhibiting reduced variations in frequency can be provided. However, as is clear from the temperature coefficient of resonant frequency TCF shown in Fig. 10 in Patent Document 2, the temperature coefficient of resonant frequency TCF may deteriorate because the above-described third medium layer made of a polycrystalline Si layer is laminated.

In consideration of the above-described current state of the technology in related art, it is an object of the present invention to provide a boundary acoustic wave device formed by laminating a plurality of media, wherein changes in characteristics due to temperature are small.

According to a first invention of the present invention, a boundary acoustic wave device is provided, the boundary acoustic wave device being characterized in that a first medium to a fourth medium are laminated in that order and an electrode is disposed at an interface between the first medium and the second medium, wherein the temperature coefficient of delay time TCD of a boundary acoustic wave or a surface acoustic wave in a structure formed by laminating the above-described fourth medium/the second medium/the electrode/the first medium takes on a positive value, the above-described fourth medium or the second medium has a positive temperature coefficient of sound velocity TCV and the above-described first medium has a negative temperature coefficient of sound velocity TCV, and the sound velocity of transverse wave in the above-described third medium is specified to be smaller than the sound velocity of transverse wave in the above-described fourth medium and/or the second medium.

In a specific aspect of the present invention, the first medium is made of a piezoelectric substrate, the second medium is made of a silicon oxide film, the third medium is made of a tantalum oxide film or a zinc oxide film, and the fourth medium is made of a silicon oxide film. In this case, the third medium made of the tantalum oxide film or the zinc oxide film exhibiting the sound velocity of transverse wave smaller than that in the silicon oxide film is disposed between the second medium and the fourth medium made of the silicon oxide film. Therefore, according to the present invention, the third medium exhibiting the sound velocity of transverse wave smaller than the sound velocities of transverse waves of the fourth medium and the second medium is disposed, so that a boundary acoustic wave device having a small absolute value of temperature coefficient of delay time TCD and good temperature characteristics can be provided reliably.

According to a second invention of the present invention, a boundary acoustic wave device is provided, the boundary acoustic wave device being characterized in that a first medium to a fourth medium are laminated in that order and an electrode is disposed at an interface between the first medium and the second medium, wherein the temperature coefficient of delay time TCD of a boundary acoustic wave or a surface acoustic wave in a structure formed by laminating the above-described fourth medium/the second medium/the electrode/the first medium takes on a negative value, the above-described fourth medium or the second medium has a negative temperature coefficient of sound velocity TCV and the above-described first medium has a positive temperature coefficient of sound velocity TCV, and the sound velocity of transverse wave in the third medium is specified to be smaller than the sound velocity of transverse wave in the fourth medium and/or the second medium.

According to a third invention of the present invention, a boundary acoustic wave device is provided, the boundary acoustic wave device being characterized in that a first medium to a fourth medium are laminated in that order and an electrode is disposed at an interface between the first medium and the second medium, wherein the temperature coefficient of delay time TCD of a boundary acoustic wave or a surface acoustic wave in a structure formed by laminating the above-described fourth medium/the second medium/the electrode/the first medium takes on a positive value, the above-described fourth medium or the second medium has a negative temperature coefficient of sound velocity TCV and the above-described first medium has a positive temperature coefficient of sound velocity TCV, and the sound velocity of transverse wave in the above-described third medium is specified to be faster than the sound velocity of transverse wave in the above-described fourth medium and/or the second medium.

According to a fourth invention of the present invention, a boundary acoustic wave device is provided, the boundary acoustic wave device being characterized in that a first medium to a fourth medium are laminated in that order and an electrode is disposed at an interface between the first medium and the second medium, wherein the temperature coefficient of delay time TCD of a boundary acoustic wave or a surface acoustic wave in a structure formed by laminating the above-described fourth medium/the second medium/the electrode/the first medium takes on a negative value, the above-described fourth medium or the second medium has a positive temperature coefficient of sound velocity TCV and the above-described first medium has a negative temperature coefficient of sound velocity TCV, and the sound velocity of transverse wave in the above-described third medium is specified to be faster than the sound velocity of transverse wave in the above-described fourth medium and/or the second medium.

In the fourth invention, preferably, the above-described first medium is made of a piezoelectric substrate, the above-described second medium and the fourth medium are made of silicon oxide films, and the above-described third medium is made of a silicon film or a silicon nitride film. In this case, the third medium made of a silicon film or a silicon nitride film exhibiting the sound velocity of transverse wave faster than that in a silicon oxide film is disposed between the second medium and the fourth medium made of the silicon oxide film. Therefore, according to the present invention, the third medium exhibiting the sound velocity of transverse wave faster than the sound velocities of transverse waves in the fourth medium and the second medium is disposed, so that a boundary acoustic wave device having a small absolute value of temperature coefficient of delay time TCD and good temperature characteristics can be provided reliably.

In the present invention (the first invention to the fourth invention), preferably, at least one IDT electrode is disposed as the electrode. That is, a boundary acoustic wave is excited efficiently by the at least one IDT electrode. Therefore, according to the present invention, a boundary acoustic wave device having a good temperature characteristic of delay time can be provided through the use of the boundary acoustic wave.

(Advantages)

In the boundary acoustic wave device according to the present invention (the first invention and the second invention), in the structure in which the first medium to the fourth medium are laminated in that order and the electrode is disposed at the interface between the first medium and the second medium, the sound velocity of transverse wave in the third medium is specified to be smaller than the sound velocity of transverse wave in the fourth medium and/or the second medium. Therefore, the absolute value of temperature characteristic of delay time TCD can be reduced and a boundary acoustic wave device having good temperature characteristics can be provided. The reason for this is believed to be as described below. The vibration energy tends to concentrate on the low sound velocity medium side easily. Therefore, in the case where the sound velocity of transverse wave in the third medium is specified to be smaller than the sound velocity of transverse wave in the fourth medium and/or the second medium, the vibration energy of the transverse wave is highly distributed into the third medium. Consequently, the vibration energy of the transverse wave is also highly distributed into the second medium and the fourth medium, so that the temperature coefficient of delay time TCD of the boundary acoustic wave can be reduced. In the third invention and the fourth invention, conversely, the sound velocity of transverse wave of the third medium is made faster and, thereby, the energy distribution of the transverse wave into the second medium and the fourth medium can be reduced, so that an advantage is achieved.

Therefore, according to the present invention, a boundary acoustic wave device in which changes in characteristics due to temperature is small can be reliably easily provided.

Brief Description of Drawings

[Fig. 1] Fig. 1 (a) and (b) are a schematic sectional front view for explaining a boundary acoustic wave device according to an embodiment of the present invention and a schematic plan view showing an electrode structure.

[Fig. 2] Fig. 2 is a schematic diagram for explaining vibration energy distribution states in individual medium layers in a boundary acoustic wave device of an embodiment.

[Fig. 3] Fig. 3 is a diagram showing changes in sound velocity of a boundary acoustic wave in the case where the film thickness of the third medium made of $Ta_2O_5$ is changed.

[Fig. 4] Fig. 4 is a diagram showing changes in electrode finger reflection index $\kappa_{12}$ of a boundary acoustic wave in the case where the film thickness of the third medium made of $Ta_2O_5$ is changed.

[Fig. 5] Fig. 5 is a diagram showing changes in temperature coefficient of delay time TCD of a boundary acoustic wave in the case where the film thickness of the third medium made of $Ta_2O_5$ is changed.

[Fig. 6] Fig. 6 is a diagram showing changes in electromechanical coefficient $K^2$ of a boundary acoustic wave in the case where the film thickness of the third medium made of $Ta_2O_5$ is changed.

[Fig. 7] Fig. 7 is a diagram schematically showing the vibration energy distribution of a boundary acoustic wave device of an embodiment in the case where the thickness of $Ta_2O_5$ defining the third medium is 0.03 $\lambda$.

[Fig. 8] Fig. 8 is a diagram schematically showing the vibration energy distribution of a boundary acoustic wave device of an embodiment in the case where the thickness of $Ta_2O_5$ defining the third medium is 0.20 $\lambda$.

[Fig. 9] Fig. 9 is a diagram showing the temperature coefficients of resonant frequency TCF in the case where the thickness of the third medium made of $Ta_2O_5$ is 0.02 $\lambda$ and 0.05 $\lambda$ and in a structure in which the third medium is not laminated.

[Fig. 10] Fig. 10 is a diagram showing the ratios of band width to the frequency of a resonator in the case where the thickness of the third medium made of $Ta_2O_5$ is 0.02 $\lambda$ and 0.05 $\lambda$ and in a structure in which the third medium is not laminated.

[Fig. 11] Fig. 11 is a diagram showing the impedance frequency characteristic and the phase frequency characteristic of individual boundary acoustic wave devices in which the thickness of $Ta_2O_5$ serving as the third medium is 0.02 $\lambda$, the thickness is 0.05 $\lambda$, or the third medium is not laminated.

[Fig. 12] Fig. 12 is a schematic sectional front view for explaining an example of boundary acoustic wave devices in related art.

Reference Numerals

| 1 | boundary acoustic wave device |
| 11 | first medium |
| 12 | second medium |
| 13 | third medium |
| 14 | fourth medium |
| 15 | laminate |
| 16 | IDT electrode |
| 17, 18 | reflector |

Best Modes for Carrying Out the Invention

The specific embodiments according to the present invention will be described below with reference to the drawings to make clear the present invention.

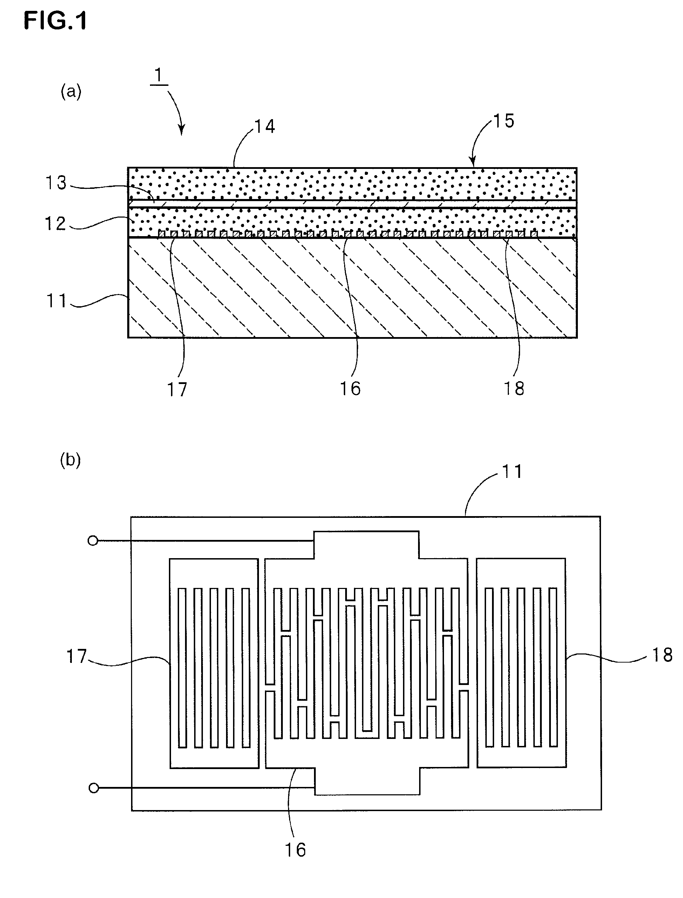

Fig. 1 (a) and (b) are a schematic sectional front view of a boundary acoustic wave device according to an embodiment of the present invention and a schematic plan view showing an electrode structure.

A boundary acoustic wave device 1 includes a laminate 15 in which a first medium 11 to a fourth medium 14 are laminated in that order. Furthermore, an electrode structure shown in Fig. 1 (b) is disposed at an interface between the first medium 11 and the second medium 12. That is, the above-described electrode structure includes an IDT electrode 16 and reflectors 17 and 18 disposed outside the IDT electrode 16 in a propagation direction of a boundary acoustic wave.

In the present embodiment, the first medium 11 is made of a 15°Y-cut X-propagation $LiNbO_3$ substrate. The first medium 11 may be formed by using $LiNbO_3$ substrates having other crystal orientations or other piezoelectric single crystal substrates, e.g., a $LiTaO_3$ substrate. The first medium 11 may be made of other piezoelectric materials, e.g., piezoelectric ceramic, and furthermore be formed having a structure in which a piezoelectric thin film is laminated on an insulating material.

In the present embodiment, the second medium 12 is made of a $SiO_2$ film serving as a silicon oxide film. In the present embodiment, the third medium 13 is made of $Ta_2O_5$ serving as a tantalum oxide film. The fourth medium 14 is made of a $SiO_2$ film serving as a silicon oxide film.

The sound velocity of transverse wave in the third medium 13 made of $Ta_2O_5$ is 1,580 m/sec. On the other hand, the sound velocity of transverse wave in the second medium and the fourth medium made of $SiO_2$ is 3,757 m/sec. That is, the sound velocity of transverse wave in the third medium is specified to be smaller than the sound velocity of transverse wave in the second medium 12 and the fourth medium 14. Furthermore, the sound velocity of transverse wave in ZnO is 2,826 m/sec and, therefore, ZnO can be used as the third medium.

In the laminated structure in which the above-described fourth medium 14/the second medium 12/ the IDT electrode 16/the first medium 11 are laminated, the temperature coefficient of delay time TCD of a boundary acoustic wave is specified to be a positive value. Incidentally, the temperature coefficient of delay time TCD is an index of a propagation property of an acoustic wave and is directly linked to an index of a device performance. The relationship with the temperature coefficient of resonant frequency TCF serving as an index of the device performance is represented by TCF = -TCD.

In the present embodiment, the sound velocity of transverse wave in the third medium 13 is specified to be smaller than the sound velocity of transverse wave in the second medium 12 and the sound velocity of transverse wave in the fourth medium 14. However, it is enough that the sound velocity of transverse wave in the third medium 13 is specified to be smaller than at least one of the sound velocity of transverse wave in the second medium 12 and the sound velocity of transverse wave in the fourth medium 14.

The temperature coefficient of sound velocity TCV takes on a positive value in the second medium and the fourth medium made of $SiO_2$. The temperature coefficient of sound velocity TCV is an index of the propagation performance of an acoustic wave except the influence of the coefficient of linear expansion and shows the tendency of changes in sound velocity due to temperature except the influence of the coefficient of linear expansion.

The temperature coefficient of sound velocity TCV in the $LiNbO_3$ substrate defining the first medium 11 takes on a negative value.

In the present embodiment, the IDT electrode 16 and the reflectors 17 and 18 are made of a laminated metal film in which an Al layer is laminated on a Au layer, and the duty ratio of the IDT electrode is specified to be 0.6.

In the boundary acoustic wave device 1 of the present embodiment, the sound velocity of transverse wave in $Ta_2O_5$ defining the third medium 13 is smaller than the sound velocity of transverse wave in the second medium 12 and the fourth medium 14 and, therefore, the energy of the transverse wave concentrates on the third medium. Consequently, the absolute value of temperature coefficient of delay time TCD of a boundary acoustic wave which propagates at an interface between the first medium 11 and the second medium 12 can be reduced, and good temperature characteristics can be obtained. This will be described more specifically on the basis of comparisons with a boundary acoustic wave device in related art.

Regarding a boundary acoustic wave device in related art configured as in the boundary acoustic wave device 1 of the above-described embodiment except that the third medium 13 and the fourth medium 14 are not included, an IDT electrode, reflectors, and a first medium and a second medium were formed under the condition shown in Table 1 described below. Regarding this boundary acoustic wave device in related art, the finite element method proposed in "Finite-Element Analysis of Periodically Perturbed Piezoelectric Waveguides" (Transactions of Institute of Electronics and Communication Engineers of Japan, Vol. J68-C No. 1. 1985/1 pp 21-27) was expanded, one strip (electrode finger) is disposed within a half-wavelength interval, and the sound velocities at an upper edge and a lower edge of a stop band of an electrically open-circuit strip and a short-circuit strip were determined. Most of the vibration energy of boundary wave concentrates on a portion from 1 λ above the IDT electrode to 1 λ below the IDT electrode. Therefore, the analysis region was specified to be a portion having a thickness of 8 λ in upward and downward directions of the IDT electrode, and the boundary conditions of the front surface and the back surface of the analysis region were elastically fixed.

Subsequently, $\kappa_{12}/k_0$ representing the amount of reflection of boundary wave at a strip and the electromechanical coefficient $K^2$ were determined on the basis of a method proposed in "Analysis of Excitation Characteristics of Interdigital SAW Transducers Using Coupling Modes Theory" (Institute of Electrons, Information and Communication Engineers of Japan, Technical Report, MW90-62, 1990, pp. 69-74). Since the frequency dispersion of sound velocity in the above-described boundary acoustic wave device prepared as an example of devices in related art was large as compared with that of the structure dealt with in "Finite-Element Analysis of Periodically Perturbed Piezoelectric Waveguides", the $\kappa_{12}/k_0$ was determined in consideration of the influence of the frequency dispersion.

The temperature coefficient of delay time TCD was determined from phase velocities $V_{15°C}$, $V_{25°C}$, and $V_{35°C}$ at the stop-band lower edge of the short-circuit strip at 15°C, 25°C, and 35°C on the basis of the following formula (1).

$$TCD = \alpha_s - (V_{35°C} - V_{15°C})/V_{25°C}(35 - 15) \qquad \text{Formula (1)}$$

In Formula (1), $\alpha_s$ represents the coefficient of linear expansion of the $LiNbO_3$ substrate in a propagation direction of boundary wave.

[Table 1]

| Configuration example in related art | $SiO_2$/IDT/15°Y-X LN |
|---|---|
| IDT(Al/Au) | thickness 0.050/0.035 λ, duty ratio 0.6 |
| Second medium ($SiO_2$) | thickness 8 λ, transverse wave sound velocity 3757 m/sec, positive TCV |
| First medium (15°Y-X $LiNbO_3$) | thickness 8 λ, negative TCV |

The characteristics of the boundary acoustic wave device in related art determined by the above-described calculation are shown in Table 2 described below.

[Table 2]

| Item | Propagation characteristics |
|---|---|
| Sound velocity $V_{25°C}$ | 3495 m/sec |
| TCD | 26.8 ppm/°C |
| $K^2$ | 17.4% |
| $\kappa_{12}/k_0$ | 0.096 |

On the other hand, the configurations of the IDT electrode 16 and the first medium 11 to the fourth medium 14 in the boundary acoustic wave device of the above-described embodiment are collectively shown in Table 3. Regarding the boundary acoustic wave device of the above-described embodiment set as shown in Table 3 described below, the propagation characteristics were calculated as in the above-described boundary acoustic wave device in related art. The results are shown in Table 4.

[Table 3]

| Embodiment | $SiO_2$/$Ta_2O_5$/$SiO_2$/IDT/15°Y-X LN |
|---|---|
| IDT(Al/Au) | thickness 0.050/0.035 λ, duty ratio 0.6 |
| Fourth medium ($SiO_2$) | thickness 8 λ, transverse wave sound velocity 3757 m/sec, positive TCV |
| Third medium ($Ta_2O_5$) | thickness 0.03 λ, transverse wave sound velocity 1580 m/sec |
| Second medium ($SiO_2$) | thickness 0.2 λ, transverse wave sound velocity 3757 m/sec, positive TCV |
| First medium (15°Y-X $LiNbO_3$) | thickness 8 λ, negative TCV |

[Table 4]

| Item | Propagation characteristics |
| --- | --- |
| Sound velocity $V_{25°C}$ | 3332 m/sec |
| TCD | 18.7 ppm/°C |
| $K^2$ | 15.1% |
| $\kappa_{12}/k_0$ | 0.091 |

As is clear from comparisons between Table 2 and Table 4, according to the boundary acoustic wave device of the present embodiment, the temperature coefficient of delay time is improved and is 18.7 ppm/°C. That is, although the sound velocity, the electromechanical coefficient $K^2$, and the $\kappa_{12}/k_0$ were changed to some extent, these changes are within practically acceptable ranges. On the other hand, it is clear that the temperature coefficient of delay time TCD is improved significantly, as described above.

The reason for reduction of absolute value and improvement of the temperature coefficient of delay time TCD is believed to be as described below.

The temperature coefficient of delay time TCD of a boundary acoustic wave is determined on the basis of the balance between the coefficient of linear expansion $\alpha_s$ of the total of the plurality of media defining boundaries and the temperature coefficients of sound velocity TCV in individual media. For example, in the case where the temperature coefficient of delay time TCD of the boundary acoustic wave takes on a positive value, if the vibration energy distribution of the boundary wave is enhanced in a material in which the temperature coefficient of sound velocity TCV of transverse wave takes on a positive value, the temperature coefficient of delay time TCD of the boundary wave is reduced. The vibration energy of the boundary acoustic wave easily concentrates on a medium exhibiting a low sound velocity. Therefore, in the case where it is desired to concentrate the vibration energy of the boundary acoustic wave on one layer of the two layers, a low sound velocity material may be used for one layer. Furthermore, in the case where one medium is separated into two layers and a relatively low sound velocity medium is inserted between the separated two layers, the vibration energy is concentrated on the low sound velocity medium and, thereby, the vibration energy distribution into the above-described separated two layers is enhanced.

In the boundary acoustic wave device in related art shown in Table 1, the temperature coefficient of delay time TCD takes on positive values. Therefore, it is believed that if the vibration energy on the $SiO_2$ layer side exhibiting the positive temperature coefficient of sound velocity TCV can be enhanced, the temperature coefficient of delay time TCD can be improved. Consequently, in the above-described embodiment, as shown in Table 3, $Ta_2O_5$ serving as the third medium in which the sound velocity of transverse wave is relatively low is disposed between the $SiO_2$ layers defining the second medium and the fourth medium. Therefore, the vibration energy of boundary wave in the second medium 12 and the fourth medium 14 made of $SiO_2$ exhibiting a positive temperature coefficient of sound velocity TCV can be enhanced.

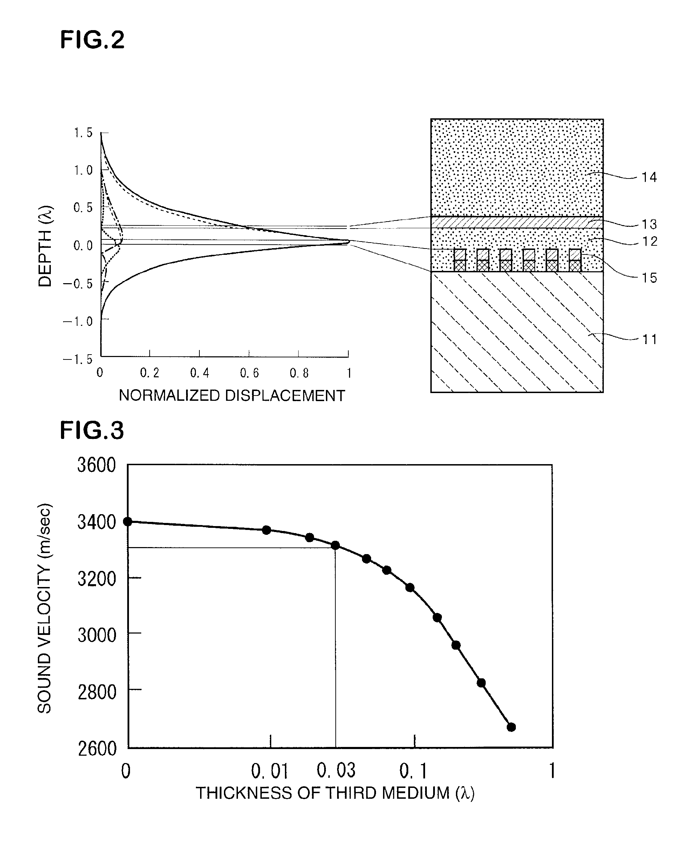

Fig. 2 is a schematic diagram showing the displacement distributions of boundary acoustic waves in the case of the above-described embodiment and in the case of related art where, in contrast to the above-described embodiment, the third medium made of $Ta_2O_5$ is not disposed. A solid line indicates the case of the above-described embodiment and a broken line indicates the case of related art. As is clear from Fig. 2, the vibration energy of the boundary acoustic wave in the second medium 12 and the fourth medium 14 is enhanced significantly by disposing the third medium 13 made of $Ta_2O_5$.

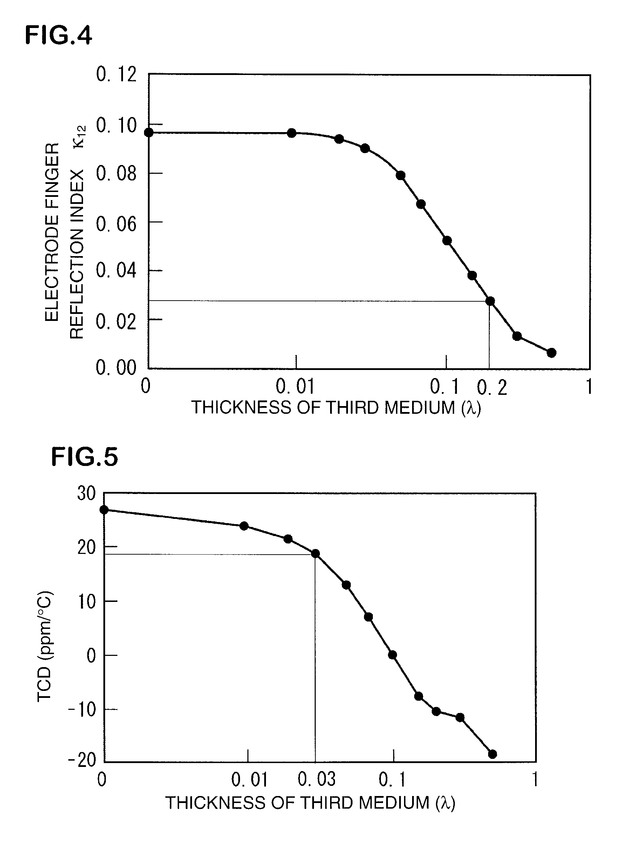

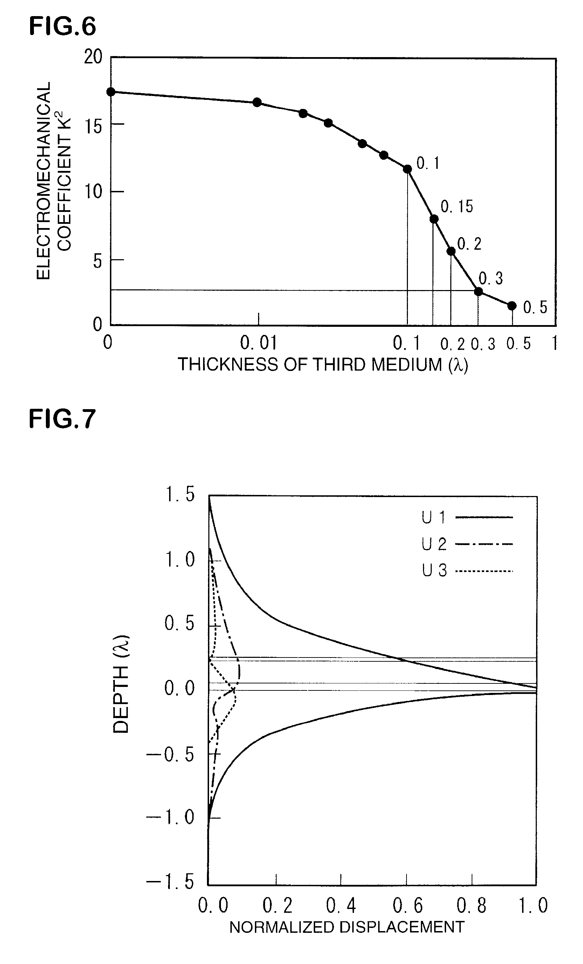

Fig. 3 to Fig. 6 are diagrams showing the relationships between the thickness of the third medium 13 and the boundary acoustic wave propagation characteristics. Specifically, Fig. 3 is a diagram showing changes in sound velocity in the case where the film thickness of the third medium 13 is changed. Fig. 4 is a diagram showing changes in strip reflection index. Fig. 5 is a diagram showing changes in temperature coefficient of delay time TCD. Fig. 6 is a diagram showing changes in electromechanical coefficient $K^2$ (%).

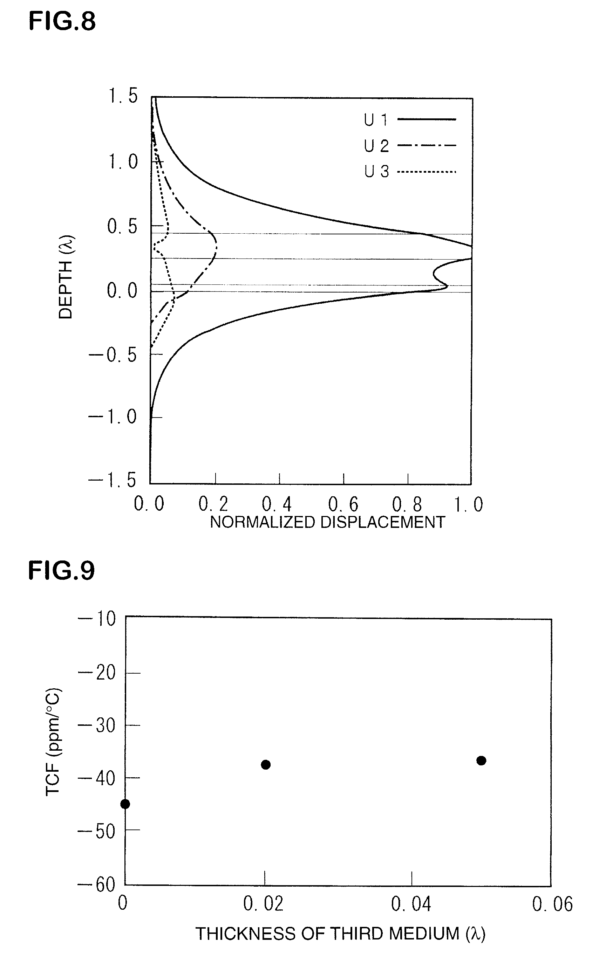

Fig. 7 is a schematic diagram showing the vibration energy distribution in the third medium made of $Ta_2O_5$ having a thickness of 0.03 $\lambda$. Fig. 8 is a schematic diagram showing the vibration energy distribution in the third medium made of $Ta_2O_5$ having a thickness of 0.20 $\lambda$.

As is clear from Fig. 3, in the case where the thickness of the third medium ($Ta_2O_5$) increases, the influence of the low sound velocity third medium increases and, thereby, the sound velocity of the boundary acoustic wave is reduced. For example, in the case where the third medium is not disposed, the sound velocity is 3,394 m/s, whereas in the case where the thickness of the third medium is 0.03 $\lambda$, the sound velocity becomes 3,332 m/s. Furthermore, if the thickness of the third medium ($Ta_2O_5$) increases, the temperature coefficient of delay time TCD shifts to the negative side, as shown in Fig. 5, on the basis of the above-described principle. For example, TCD is 27 ppm/°C in the case where the third medium is not disposed, whereas TCD becomes 18 ppm/°C in the case where the thickness of the third medium is 0.03 $\lambda$. Moreover, as shown in Fig. 7 and Fig. 8, as the thickness of $Ta_2O_5$ increases to 0.20 $\lambda$, the vibration energy distributed into the $LiNbO_3$ substrate decreases, and the electromechanical coefficient $K^2$ is reduced. That is, in the case where the thickness of the $Ta_2O_5$ is 0.3 $\lambda$, as is clear from Fig. 6, the electromechanical coefficient $K^2$ is reduced to 2.4% and, therefore, the usability is deteriorated.

Furthermore, as is clear from Fig. 4, as the thickness of the third medium 13 made of $Ta_2O_5$ increases, the $\kappa_{12}$ indicating the reflection coefficient of the strip is reduced. In particular, when the thickness of $Ta_2O_5$ is 0.2 $\lambda$, the $\kappa_{12}$ becomes a small 0.026. Therefore, if the $\kappa_{12}$ becomes less than 0.026, it is necessary to increase the number of reflector regarding the one-port type boundary acoustic wave resonator of the above-described embodiment in which strip type reflectors 17 and 18 are disposed on both sides of the IDT electrode 16. And, in the case where a longitudinally coupled resonator filter is provided, which is a boundary acoustic wave device using a resonator structure, the number of reflector is increased. Consequently, unfavorably, size increasing of the boundary acoustic wave device occurs. Therefore, it is desirable that the thickness of the third medium 13 made of $Ta_2O_5$ is preferably 0.30$\lambda$ or less, and more preferably 0.20 $\lambda$ or less.

Next, a one-port type boundary acoustic wave device was specifically prepared following the above-described embodiment, and the temperature coefficient of resonant frequency TCF and the ratio of the band width to the frequency were measured.

That is, the period $\lambda$ of the IDT electrode 16, the configuration and the thickness of the IDT electrode 16, the film thicknesses and materials of the first medium 11 to the fourth medium 14 were set as shown in Table 5 described below.

Furthermore, the design parameters of the IDT electrode 16 were specified as described below.

The number of pairs of electrode fingers: 60 pairs

Intersection width: 30 $\lambda$

Opening width: 30.4 $\lambda$

Apodization: presence, intersection width of center of IDT 30 $\lambda$, intersection width of both ends of IDT 15 $\lambda$

The number of electrode fingers of reflector: 51 fingers

Period of IDT and reflector $\lambda$: 3.42 $\mu$m (electrode fingers disposition pitch 0.8 $\mu$m)

Line width of electrode fingers: 0.855 $\mu$m

Space width between electrode fingers: 0.855 $\mu$m

[Table 5]

| Item | Dimension |
|---|---|
| IDT period $\lambda$ | 3.42 $\mu$m |
| IDT(NiCr/Ti/Al/Ti/Ni/Au/Ni/Ti) | thickness 20/20/100/20/20/140/20/20 nm |
| Fourth medium ($SiO_2$) | thickness 6000 nm |
| Third medium ($Ta_2O_5$) | thickness 170 nm |
| Second medium ($SiO_2$) | thickness 680 nm |
| First medium (15°Y-X $LiNbO_3$) | thickness 500 $\mu$m |

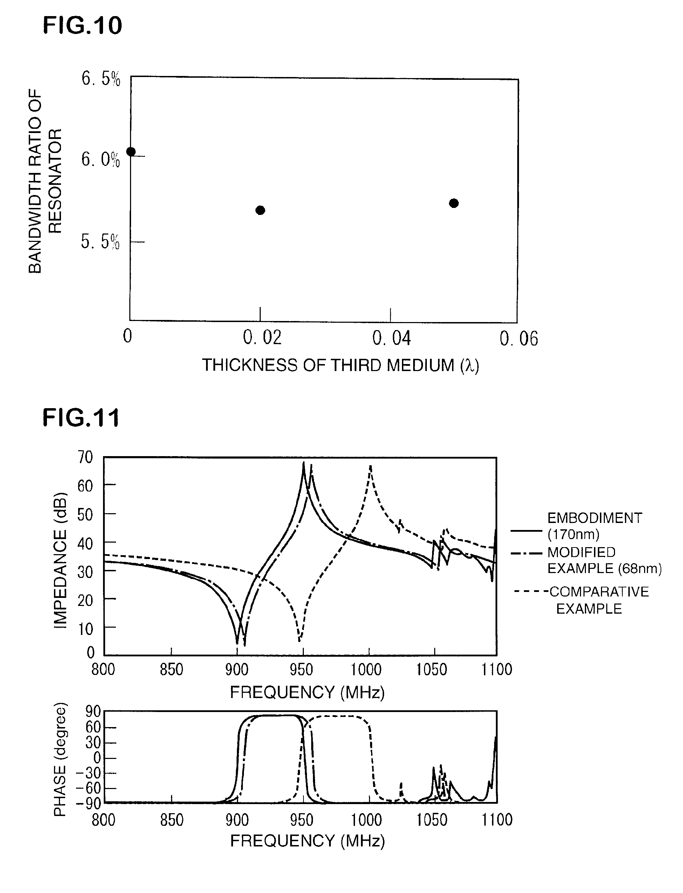

The thickness of the third medium 13 was specified to be 170 nm, that is, 0.05 $\lambda$. However, in addition, a boundary acoustic wave device of a modified example was prepared, in which the thickness of the third medium 13 was specified to be 0.02 $\lambda$ (68 nm). Furthermore, for the purposes of comparison, a boundary acoustic wave device was prepared as in the above-described prototype example except that the thickness of the third medium was 0 $\lambda$, that is, the third medium 13 was not disposed. Regarding these boundary acoustic wave devices, the temperature coefficient of resonant frequency TCF and the ratio of the band width to the frequency were measured. The results are shown in Fig. 9 and Fig. 10. Here, the ratio of the band width to the frequency was determined from (anti-resonant frequency - resonant frequency)/resonant frequency.

As is clear from Fig. 9 and Fig. 10, according to the specifically prototyped boundary acoustic wave devices of the above-described embodiment and the modified example, the absolute values of the temperature coefficients of resonant frequency TCF can be reduced as compared with that of the boundary acoustic wave device not including the third medium, and the ratio of the band width to the frequency does not change significantly. Therefore, it is clear that the frequency temperature characteristic can be improved without reducing the ratio of the band width to the frequency.

Fig. 11 is a diagram showing the impedance and the phase characteristics of three types of boundary acoustic wave devices prepared as described above. As is clear from Fig. 11, regarding the boundary acoustic wave devices of the embodiment and the modified example, in which the third medium 13 was used, the impedance ratio, that is, the top-to-valley ratio, which is a ratio of the impedance at an anti-resonant frequency to the impedance at a resonant frequency becomes large as compared with that of the comparative example in which the third medium is not included and, therefore, the characteristics are improved.

Most of piezoelectric materials have negative temperature coefficients of sound velocity TCV, and devices thereof have negative temperature coefficients of resonant frequency TCF. Therefore, the temperature coefficient of resonant frequency TCF of the device can be corrected to the positive side by using a material having a positive temperature coefficient of sound velocity TCV for the second medium 12 and the fourth medium 14. The usability can be enhanced by using $SiO_2$ having a positive temperature coefficient of sound velocity TCV as the second medium 12 and the fourth medium 14. That is, the absolute value of temperature coefficient of resonant frequency TCF can be reduced. On the other hand, $Ta_2O_5$ exhibits a low sound velocity, and is a heavy, hard dielectric material. Therefore, in the case where thin $Ta_2O_5$ serving as the third medium 13 is disposed between the second medium 12 and the fourth medium 14 made of $SiO_2$, the energy can be moved from the first medium 11 to the second medium 12 side. Furthermore, $SiO_2$ and $Ta_2O_5$ exhibit excellent heat resistance and are chemically stable. Consequently, the boundary acoustic wave device 1 of the above-described embodiment not only exhibits small changes in characteristics due to temperature, but also exhibits excellent heat resistance and stability. In addition, the reliability is also excellent. Moreover, the second medium 12 and the fourth medium 14 may be made of different materials.

Regarding the above-described embodiment, the temperature coefficient of delay time TCD of the boundary acoustic wave takes on a positive value in the structure in which the fourth medium/the second medium/the electrode/the first medium are laminated. In the structure, the fourth medium or the second medium have a positive temperature coefficient of sound velocity TCV and the first medium has a negative temperature coefficient of sound velocity TCV. However, the present invention is not limited to such a structure. The delay time temperature characteristic can also be improved in the following second structure in which the sound velocity of transverse wave in the third medium is specified to be smaller than that in the fourth medium and/or the second medium, and in the third and fourth structures in which, conversely, the sound velocity of transverse wave in the third medium is specified to be faster.

Second structural example: a structure in which the temperature coefficient of delay time TCD of the boundary acoustic wave takes on a negative value in the laminated structure of the fourth medium/the second medium/the electrode/the first medium, the fourth medium or the second medium has a negative temperature coefficient of sound velocity TCV, and the first medium has a positive temperature coefficient of sound velocity TCV.

Third structural example: a structure in which the temperature coefficient of delay time TCD of the boundary acoustic wave takes on a positive value in the laminated structure of the fourth medium/the second medium/the electrode/the first medium, the fourth medium or the second medium has a negative temperature coefficient of sound velocity TCV, and the first medium has a positive temperature coefficient of sound velocity TCV.

Fourth structural example: a structure in which the temperature coefficient of delay time TCD of the boundary acoustic wave takes on a negative value in the laminated structure of the fourth medium/the second medium/the electrode/the first medium, the fourth medium or the second medium has a positive temperature coefficient of sound velocity TCV, and the first medium has a negative temperature coefficient of sound velocity TCV.

In the above-described embodiment, the one-port type boundary acoustic wave resonator has been described. However, the boundary acoustic wave device according to the present invention can be configured to have various electrode structures. That is, the boundary acoustic wave device may be a longitudinally coupled or transversely coupled boundary acoustic wave resonator filter including at least two IDTs or a ladder filter in which a plurality of boundary acoustic wave resonators are connected in a ladder arrangement. Furthermore, the acoustic wave device according to the present invention can be used for optical devices, e.g., boundary acoustic wave optical switches and boundary acoustic wave optical filters, and be widely used for general devices taking advantage of the boundary acoustic wave.

In the production of the boundary acoustic wave device according to the present invention, prior to the formation of the second medium 12 to the fourth medium 14, the thicknesses of the IDT electrode 16, the second medium 12, and/or the third medium 13 can be adjusted by reducing the thicknesses of the IDT electrode and the second medium 12 or the third medium 13 through reverse sputtering, ion beam milling, reactive ion etching, wet etching, polishing, or the like or by increasing the thickness through additional film formation by sputtering or a deposition method, e.g., evaporation.

In the present invention, as shown in Table 5, the electrode structure may be made of a laminated film composed of a plurality of metals.

Furthermore, the materials for defining the first medium to the fourth medium in the present invention are not specifically limited. That is, various dielectric materials can be used as the media. Examples of such media include one type selected from the group consisting of lithium niobate, potassium niobate, lithium tantalate, lithium tetraborate, langasite, langanite, quartz, PZT, ZnO, AIN, silicon oxide, glass, silicon, sapphire, silicon nitride, and carbon nitride.

Moreover, the medium is not necessarily made of a single material, but may have a laminated structure in which a plurality of medium layers are laminated. That is, at least one medium of the first medium to the fourth medium may have a laminated structure in which a plurality of material layers are laminated.

In addition, the boundary acoustic wave device according to the present invention may be provided with an external protective layer for enhancing strength and preventing infiltration of corrosive gases and the like. The boundary acoustic wave device may have a structure of being enclosed in a package in a case where size reduction is not required.

The above-described protective layer may be made of insulating materials, e.g., titanium oxide, aluminum nitride, and aluminum oxide, be made of metal films of Au, Al, W, and the like, and be made of resin films of epoxy resins and the like.

**Claims**

1.  A boundary acoustic wave device **characterized in that** a first medium to fourth medium are laminated **in that** order and an electrode is disposed at an interface between the first medium and the second medium in the boundary acoustic wave device,
    wherein the temperature coefficient of delay time TCD of a boundary acoustic wave or a surface acoustic wave in a structure formed by laminating the fourth medium/the second medium/the electrode/the first medium takes on a positive value,
    the fourth medium or the second medium has a positive temperature coefficient of sound velocity TCV and the first medium has a negative temperature coefficient of sound velocity TCV, and
    the sound velocity of transverse wave in the third medium is specified to be smaller than the sound velocity of transverse wave in the fourth medium and/or the second medium.

2.  The boundary acoustic wave device according to Claim 1, wherein the first medium is made of a piezoelectric substrate, the second medium is made of a silicon oxide film, the third medium is made of a tantalum oxide film or a zinc oxide film, and the fourth medium is made of a silicon oxide film.

3.  A boundary acoustic wave device **characterized in that** a first medium to fourth medium are laminated **in that** order and an electrode is disposed at an interface between the first medium and the second medium in the boundary acoustic wave device,
    wherein the temperature coefficient of delay time TCD of a boundary acoustic wave or a surface acoustic wave in a structure formed by laminating the fourth medium/the second medium/the electrode/the first medium takes on a negative value,
    the fourth medium or the second medium has a negative temperature coefficient of sound velocity TCV and the first medium has a positive temperature coefficient of sound velocity TCV, and
    the sound velocity of transverse wave in the third medium is specified to be smaller than the sound velocity of transverse wave in the fourth medium and/or the second medium.

4.  A boundary acoustic wave device **characterized in that** a first medium to fourth medium are laminated **in that** order and an electrode is disposed at an interface between the first medium and the second medium in the boundary acoustic wave device,
    wherein the temperature coefficient of delay time TCD of a boundary acoustic wave or a surface acoustic wave in a structure formed by laminating the fourth medium/the second medium/the electrode/the first medium takes on a positive value,
    the fourth medium or the second medium has a negative temperature coefficient of sound velocity TCV and the first medium has a positive temperature coefficient of sound velocity TCV, and
    the sound velocity of transverse wave in the third medium is specified to be faster than the sound velocity of transverse wave in the fourth medium and/or the second medium.

5.  A boundary acoustic wave device **characterized in that** a first medium to fourth medium are laminated **in that** order and an electrode is disposed at an interface between the first medium and the second medium in the boundary acoustic wave device,
    wherein the temperature coefficient of delay time TCD of a boundary acoustic wave or a surface acoustic wave in a structure formed by laminating the fourth medium/the second medium/the electrode/the first medium takes on a negative value,
    the fourth medium or the second medium has a positive temperature coefficient of sound velocity TCV and the first medium has a negative temperature coefficient of sound velocity TCV, and
    the sound velocity of transverse wave in the third medium is specified to be faster than the sound velocity of transverse wave in the fourth medium and/or the second medium.

6. The boundary acoustic wave device according to Claim 5, wherein the first medium is made of a piezoelectric substrate, the second medium and the fourth medium are made of silicon oxide films, and the third medium is made of a silicon film or a silicon nitride film.

7. The boundary acoustic wave device according to any one of Claims 1 to 6, comprising at least one IDT electrode as the electrode.

# FIG.1

(a)

(b)

## FIG.2

NORMALIZED DISPLACEMENT

## FIG.3

THICKNESS OF THIRD MEDIUM (λ)

## FIG.4

## FIG.5

## FIG.6

## FIG.7

## FIG.8

## FIG.9

## FIG.10

## FIG.11

## FIG.12

## INTERNATIONAL SEARCH REPORT

| International application No. |
| --- |
| PCT/JP2007/059760 |

**A.   CLASSIFICATION OF SUBJECT MATTER**
*H03H9/25*(2006.01)i, *H01L41/09*(2006.01)i, *H01L41/18*(2006.01)i, *H03H9/145* (2006.01)i

According to International Patent Classification (IPC) or to both national classification and IPC

**B.   FIELDS SEARCHED**

Minimum documentation searched (classification system followed by classification symbols)
H03H3/007-H03H3/10, H03H9/00-H03H9/76

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

**C.   DOCUMENTS CONSIDERED TO BE RELEVANT**

| Category* | Citation of document, with indication, where appropriate, of the relevant passages | Relevant to claim No. |
| --- | --- | --- |
| Y<br>A | WO 98/52279 A1  (Hitachi, Ltd.),<br>19 November, 1998 (19.11.98),<br>Page 10; Fig. 12<br>(Family: none) | 5-7<br>1-4 |
| Y<br>A | JP 7-212174 A  (Hitachi, Ltd.),<br>11 August, 1995 (11.08.95),<br>Par. No. [0013]<br>(Family: none) | 5-7<br>1-4 |
| Y<br>A | JP 11-55070 A  (Matsushita Electric Industrial Co., Ltd.),<br>26 February, 1999 (26.02.99),<br>Par. No. [0023]<br>& US 5998907 A1 | 5-7<br>1-4 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    02 August, 2007 (02.08.07) | Date of mailing of the international search report<br>    14 August, 2007 (14.08.07) |
| --- | --- |
| Name and mailing address of the ISA/<br>    Japanese Patent Office | Authorized officer |
| Facsimile No. | Telephone No. |

Form PCT/ISA/210 (second sheet) (April 2005)

# EP 2 023 485 A1

<table>
<tr><td colspan="2"><b>INTERNATIONAL SEARCH REPORT</b></td><td>International application No.<br><br>PCT/JP2007/059760</td></tr>
</table>

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 2003-512637 A (Tournois, Pierre),<br>02 April, 2003 (02.04.03),<br>Par. No. [0047]<br>& US 6737941 B1        & EP 1222735 A<br>& WO 01/29964 A1 | 5-7<br>1-4 |

Form PCT/ISA/210 (continuation of second sheet) (April 2005)

# EP 2 023 485 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004070946 A

- WO 2005093949 A

**Non-patent literature cited in the description**

- Finite-Element Analysis of Periodically Perturbed Piezoelectric Waveguides. *Transactions of Institute of Electronics and Communication Engineers of Japan,* January 1985, vol. J68-C (1), 21-27

- Analysis of Excitation Characteristics of Interdigital SAW Transducers Using Coupling Modes Theory. *Institute of Electrons, Information and Communication Engineers of Japan, Technical Report, MW90-62,* 1990, 69-74